# EUROPEAN PATENT APPLICATION

(11) **EP 4 661 292 A1**
(43) Date of publication of application: **10.12.2025**
(21) Application number: 25180197.3
(22) Date of filing: 02.06.2025
(51) Int. Cl.: H03K 17/12, H03K 17/687, H02H 3/087, H03K 17/0812, H03K 17/0814, H02H 7/26, H03K 17/082

(54) **DC POWER DISTRIBUTION AND PROTECTION SYSTEM**

(30) Priority: 05.06.2024 GB 202407967
(71) Applicant: Rolls-Royce Deutschland Ltd & Co KG, 15827 Blankenfelde-Mahlow (DE)
(72) Inventor: GAJANAYAKE, Chandana, 15827 Blankenfelde-Mahlow (DE); MOHAMED HALICK, Mohamed Sathik, 15827 Blankenfelde-Mahlow (DE); HO, Anh Vu, 15827 Blankenfelde-Mahlow (DE)

(57) **Abstract**

A DC power distribution and protection system that comprises a DC power source (2) and a power bus (3, 4) connecting the power source (2) and a load (R). A solid state power controller (100) is arranged in a positive voltage rail (3) or a negative voltage rail (4) of the power bus. The solid state power controller (100) comprises a first switching instance (S1, S2) that comprises a plurality of semiconductor switches (S11-S15, S21-S25) arranged in parallel. Further, an auxiliary switching instance (SA) is arranged between the positive voltage rail (3) and the negative voltage rail (4). A controller (5) is provided and configured to receive information or determine that one of the semiconductor switches (S11-S15, S21-S25) of the first switching instance (S1, S2) has a fault condition. In such case, the controller (5) is further configured to control the first switching instance (S1, S2) and the auxiliary switching instance (SA) such that the semiconductor switches (S11-S15, S21-S25) of the first switching instance (S1, S2) are switched off and the auxiliary switching instance (SA) is switched on, wherein a short-circuit current is guided through the auxiliary switching instance (SA) and the faulty semiconductor switch (S15, S24) in order to remove the faulty semiconductor switch (S15, S25).

## Description

### FIELD

The present disclosure relates a DC power distribution and protection system and a method for servicing such DC power distribution and protection system in case of failure of a semiconductor switch.

### BACKGROUND

With increased penetration of electrical systems and the progression towards full electric and hybrid propulsion systems, the use of energy storage systems and DC power distribution has gained increased use. Multiple loads and sources may be connected to a DC distribution system such as a hybrid propulsion system. In such system, adequate DC protection devices are required. Due to the fact that SSPCs (Solid State Power Controllers, also referred to a Solid State Protection Controllers) show a fast response time, eliminate arcing during turn-off, and have a high reliability, SSPCs are preferred over electromechanical switches. SSPCs combine the functions of connecting loads to a DC bus bars and protecting electrical installations against overload and short circuits.

However, size, weight and power loss are limiting factors in the use of SSPCs. In order to implement high current and high voltage applications in an effective manner, it is known to connect several semiconductor switches such as MOSFETs in parallel in an SSPC. However, when a number of parallel semiconductor switches is used, there is a risk that failure of single semiconductor switch leads to failure or shutdown of the complete SSPC, thereby causing a disruption in the operability of the system.

There is a need to provide a DC power distribution and protection system and a corresponding method that avoid that failure of a semiconductor switch of an SSPC leads to failure of the complete SSPC or at least provide a useful alternative to known DC power distribution and protection systems and methods.

### SUMMARY

In a first aspect there is provided a DC power distribution and protection system is provided for. The DC power distribution and protection system comprises a DC power source having a positive terminal and a negative terminal, a power bus connecting the power source and a load, wherein the power bus comprises a positive voltage rail connected to the positive terminal and a negative voltage rail connected to the negative terminal, and a solid state power controller arranged in the positive voltage rail or negative voltage rail, wherein the solid state power controller comprises a first switching instance that comprises a plurality of semiconductor switches arranged in parallel, and an auxiliary switching instance arranged between the positive voltage rail and the negative voltage rail.

The system further comprises a controller which is configured to receive information or determine that one of the semiconductor switches of first switching instance has a fault condition. In such case, the controller is further configured to control the first switching instance and the auxiliary switching instance such the semiconductor switches of the first switching instance are switched off, and the auxiliary switching instance is switched on, wherein a short-circuit current is guided through the auxiliary switching instance and the faulty semiconductor switch in order to remove the faulty semiconductor switch.

Aspects of the invention are thus based on the idea to address the problem of a faulty semiconductor switch by removing the faulty semiconductor switch in that a controlled short-circuit current is provided that flows through the faulty semiconductor switch and thus burns the faulty semiconductor switch or an element arranged in series with the faulty semiconductor switch, thereby removing the faulty semiconductor switch from the solid state power controller without damaging the other components in the system.

To this end, a system topology is provided that comprises an auxiliary switching instance arranged between the positive voltage rail and the negative voltage rail, wherein the auxiliary switching instance can be controlled to provide for a short-circuit current that is guided through the auxiliary switching instance and - as the semiconductor switches of the first switching instance are switched off - the faulty semiconductor switch only, for which the switching off does not have an effect due to its faulty nature. At the same time, as the semiconductor switches of the first switching instance are switched off, the healthy semiconductor switches are not affected by the operation. The auxiliary switching instance is only operated for servicing in case of a faulty semiconductor switch but, under normal conditions, is not operated.

Aspects of the present invention thus service a solid state power controller by removing a faulty semiconductor switch without damaging the other components, thereby allowing to bring the solid state power controller back into operation.

The auxiliary switching instance may be considered part of the solid state power controller. Also, it may be controlled by a gate driver of the solid state power controller. However, in principle, the auxiliary switching instance may be provided as a separate part of the circuit as well.

The fault that a faulty semiconductor switch may experience may be of different nature. In particular, the fault may be that the semiconductor switch is short-circuited. In such case, after the faulty semiconductor switch has been burned, the current path through the faulty semiconductor switch is opened and no current is flowing through the faulty semiconductor switch anymore.

In some embodiments, the controller is configured to operate the auxiliary switching instance such that a pre-determined continuous stream of pulses is applied when a fault condition is present for the purpose of controlling the short circuit current and duration. By applying pulses, the faulty semiconductor switch or an element arranged in series with the semiconductor switch such as a fuse can be blown off safely and in a controlled manner without damaging the auxiliary switching instance (which may be damaged if a short-circuit current is present for a longer period of time).

The applied continuous pulsed stream may follow a high-frequency pulse pattern. The pulses may be pulse-width modulated. The pulses are applied to one or several control terminals of the auxiliary switching instance and may be driver signals of a driver which is controlled by the controller. By means of the continuous stream of pulses, a pulsed current is created which burns the faulty semiconductor switch or an element arranged in series with the faulty semiconductor switch.

In some embodiments, the auxiliary switching instance also comprises a plurality of semiconductor switches arranged in parallel, wherein the semiconductor switches of the auxiliary switching instance are controlled by the controller to be switched on when a fault condition is present. Each of the semiconductor switches of the auxiliary switching instance comprises a control terminal which is controlled by a driver (individual or common), wherein the driver is controlled by the controller.

In a further embodiment, the short-circuit current is provided such that the faulty semiconductor switch is burned by the controlled short-circuit current, thereby removing the faulty semiconductor switch. For example, if the faulty semiconductor switch had been short-circuited before being burned, there is an opened circuit after the faulty semiconductor switch has been burned. According to this embodiment, it is the faulty semiconductor switch itself which is burned.

In another embodiment, a series fuse is arranged in series with each of the semiconductor switches, wherein the short-circuit current is provided such that the series fuse associated with the faulty semiconductor switch is burned in order to remove the faulty semiconductor switch. According to this embodiment, it is not the faulty semiconductor switch itself which is burned but a fuse arranged in series with the semiconductor switch.

In a further embodiment, the controller is configured to control the auxiliary switching instance such that the auxiliary switching instance is shut off during normal operation of the solid state power controller. As already mentioned, the auxiliary switching instance is only activated in the event of a fault. It is switched off during normal operation.

In a further embodiment, the number of semiconductor switches arranged in parallel in the first switching instance is such that a level of redundancy is provided for. The idea of such a redundancy is to ensure that the solid state power controller can still operate normally after one of its semiconductor switches has been deactivated in accordance with the invention.

Each semiconductor switch may be arranged in combination with an antiparallel diode in the first switching instance. Such diodes give current that flows in the opposite direction a path to flow, thereby avoiding high voltage peaks eventually caused by inductive currents.

In a further embodiment, one or several transient voltage suppressor diodes are arranged between the positive voltage rail and the negative voltage rail. Their purpose is to suppress transient voltage spikes.

In a further embodiment, the multiple semiconductor switches of the first switching instance are controlled by a single (common) gate driver. This is convenient as the number of gate drivers can be limited in this way. However, alternatively, the semiconductor switches may be driven by individual gate drivers as well. The gate driver or gate drivers may be part of the solid state power controller and are controlled by the controller.

Generally, the semiconductor switches each comprise a control terminal (such as a Gate-Terminal in case of a MOSFET) which is controlled by a common or individual gate driver.

In some embodiments, the controller is configured to determine that one of the semiconductor switches of the first switching instance has a fault by means of the gate driver providing an error signal for the faulty switch to the controller. Accordingly, it is relied upon information from the gate driver to determine if a semiconductor switch is faulty. Alternatively or additionally, sensors (such as heat sensors) could be located next to the semiconductor switches to detect and report a fault.

In some embodiments, the controller is configured to run a diagnosis test when receiving an error indication before determining that a particular switch has a fault. The diagnosis test is carried out to eliminate other reasons for the fault than a faulty semiconductor switch. If the diagnostic tests can rule out all other conditions, failure of a semiconductor switch can be confirmed.

In some embodiments, the controller is configured to run a diagnosis test that comprises setting all semiconductor switches of the first switching instance into the **OFF** state while turning the auxiliary switching instance ON with a frequency pulse pattern. If the semiconductor switches are healthy and not short-circuited, current from input or output sides will not flow. The detection of a current is an indication of a short-circuited device.

So far, a DC power distribution and protection system has been considered in which the solid state power controller comprises a single, first, switching instance in the positive voltage rail or in the negative voltage rail. However, in embodiments, there may be provided a further, second, switching instance in the same voltage rail (such as the positive voltage rail). This allows for a bidirectional SSPC architecture that allows bidirectional control of the current flow between a DC power source and a load, while a single switching instance allows for unidirectional control of the current flow only.

Accordingly, in some embodiments, the solid state power controller further comprises a second switching instance arranged in the same voltage rail as the first switching instance, wherein the second switching instance also comprises a plurality of semiconductor switches arranged in parallel, and wherein the controller is configured to receive information or determine that one of the semiconductor switches of the second first switching instance has a fault condition. In such case, the controller is further configured to control the second switching instance and the auxiliary switching instance such that the semiconductor switches of the second switching instance are switched off, and the auxiliary switching instance is switched on, wherein a short-circuit current is guided through the auxiliary switching instance and the faulty semiconductor switch of the second switching instance in order to remove the faulty semiconductor switch.

Accordingly, the same principles of servicing a faulty semiconductor switch are implemented with respect to the second switching instance as with the first switching instance.

When a first and a second switching instance are provided, the auxiliary switching instance may be arranged between the positive voltage rail and the negative voltage rail such that one terminal of the auxiliary switching instance is connected to a point in between the first and second switching instances. This allows to guide current from/to the auxiliary switching instance both to/from the first switching instance and the second switching instance.

The semiconductor switches may be implemented as MOSFET, IGBT, GaN or SiC transistors in embodiments. The gate of such semiconductor switch is the control terminal to which the driver signal of the SSPC driver is applied.

The DC power distribution and protection system may be implemented in a system in which the load is a power converter, wherein a load capacitor is additionally arranged between the positive voltage rail and the negative voltage rail.

In a second aspect there is provided a method for servicing a DC power distribution and protection system in case of failure of a semiconductor switch. The DC power distribution and protection system in which the method is carried out comprises a DC power source having a positive terminal and a negative terminal, a power bus connecting the power source and a load, the power bus comprising a positive voltage rail connected to the positive terminal and a negative voltage rail connected to the negative terminal, a solid state power controller arranged in the positive voltage rail or negative voltage rail, wherein the solid state power controller comprises a first switching instance that comprises a plurality of semiconductor switches arranged in parallel, and an auxiliary switching instance arranged between the positive voltage rail and the negative voltage rail. The method comprises: determining if one of the semiconductor switches of the first switching instance has a fault condition, in such case controlling the first switching instance and the auxiliary switching instance such that a short-circuit current is guided through the auxiliary switching instance and the faulty semiconductor switch (wherein the semiconductor switches of the first switching instance are switched off and the auxiliary switching instance is switched on), and removing the faulty semiconductor switch by means of the short-circuit current.

The method allows to service a solid state power controller by removing a faulty semiconductor switch without damaging the other components, thereby allowing to bring the solid state power controller back into operation.

In embodiments, the faulty semiconductor switch itself or a series fuse arranged in series with the faulty semiconductor switch is burned by the short-circuit current. Further, it may be provided that the auxiliary switching instance is operated by applying a pre-determined continuous stream of pulses when a fault condition is present. In a further embodiment, the method further comprises a running a diagnosis test when receiving an error indication and before determining that a particular switch has a fault.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### BRIEF DESCRIPTION OF THE DRAWINGS

The invention will be explained in more detail on the basis of exemplary embodiments with reference to the accompanying drawings in which:
FIG. 1 is an embodiment of a DC power distribution and protection system that implements a bidirectional SSPC, wherein the bidirectional SSPC includes first and second switching instances which each comprise a plurality of semiconductor switches arranged in parallel, and wherein further an auxiliary switching instance is provided that allows to guide a short-circuit current through a faulty semiconductor switch to burn and remove the faulty semiconductor switch;
FIG. 2 is the DC power distribution and protection system of FIG. 1, wherein a short-circuit current is guided through the auxiliary switching instance and a particular faulty semiconductor switch of the first switching instance;
FIG. 3 is an embodiment of a DC power distribution and protection system which is similar to the embodiment of FIG. 1 except that a series fuse is arranged in series with each of the semiconductor switches of the first and second switching instances, wherein a series fuse is burned in case of a short-circuit current;
FIG. 4 is a flowchart of a method used in the DC power distribution and protection system of FIG. 1, the method allowing to service an SSPC by removing a faulty semiconductor switch;
FIG. 5 is a flowchart of a more detailed method for servicing a DC power distribution and protection system in case of a faulty semiconductor switch;
FIG. 6 is an embodiment of a DC power distribution and protection system similar to the embodiment of FIG. 1, wherein a short-circuit current is guided through the auxiliary switching instance and a particular faulty semiconductor switch of the second switching instance;
FIG. 7 is a standard architecture of a unidirectional SSPC; and
FIG. 8 is a standard architecture of a bidirectional SSPC.

### DETAILED DESCRIPTION

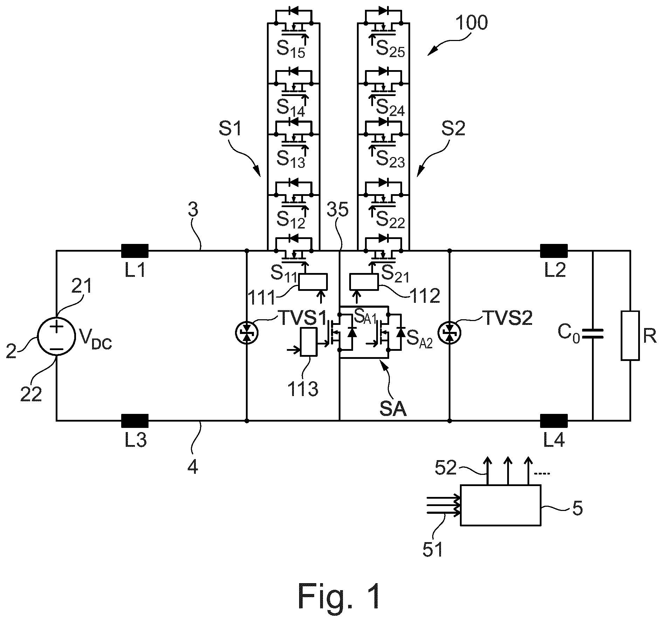

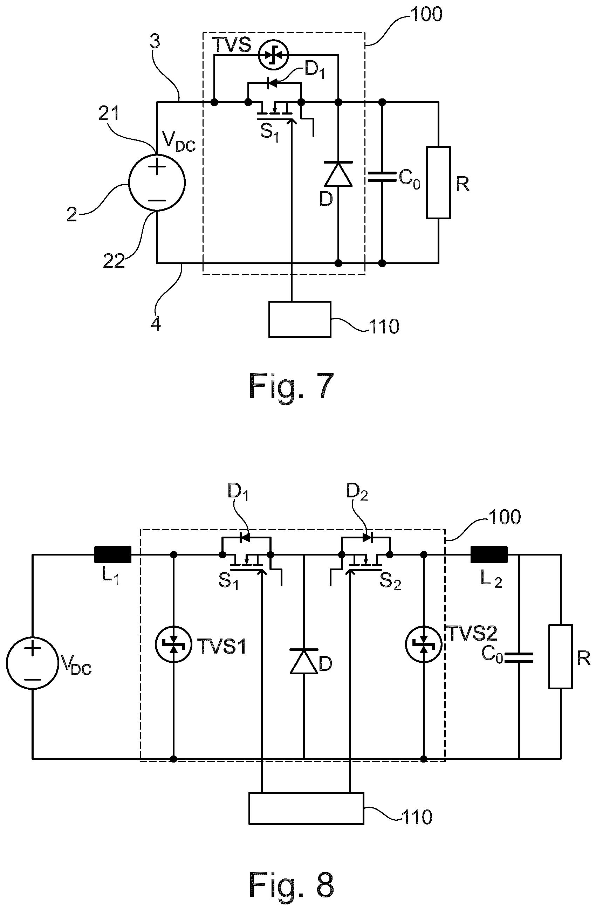

Before discussing embodiments of the present invention with respect to FIGS. 1 to 6, the background of the invention is discussed with respect to FIGS. 7 and 8 to provide for a better understanding of the present invention.

FIG. 7 shows a DC power distribution and protection system that comprises a unidirectional solid state power controller 100, in the following referred to as SSPC. The system comprises a DC power source 2 (such as a DC battery) that has a positive terminal 21 and a negative terminal 22. Between the positive terminal 21 and the negative terminal 22 a battery voltage V_{DC} is present. A positive voltage rail 3 is connected to the positive terminal 21 and a negative voltage rail 4 is connected to the negative terminal 22. The positive voltage rail 3 and the negative voltage rail 4 form a high-voltage bus.

The system further comprises a load R, wherein the load R may be formed in a plurality of manners. In examples, the load may be a power converter such as an inverter and/or an electric motor. A capacitive load generally depicted as C₀ is arranged in parallel to the load R and extends between the positive voltage rail 3 and the negative voltage rail 4. For example, the capacitive load may be formed by DC link capacitors or include such capacitors.

The SSPC 100 comprises a semiconductor switch S1 with an antiparallel bypass diode D1 arranged in the positive voltage rail 3. The switch S1 may be a MOSFET (metal-oxide-semiconductor field-effect transistor), GaN (Gallium Nitride), SiC (Silicon Carbide) or IGBT (Insulated Gate Bipolar Transistor) switch. A further diode D may extend between the positive voltage rail 3 and the negative voltage rail 4. Further, optionally, a transient voltage suppressor diode TVS may extend in parallel to the semiconductor switch S1.

The SSPC 100 further comprises a gate driver 110 that is responsible for controlling the switching of the semiconductor switch S1 and provides the necessary gate signal to the gate of semiconductor switch S1. The SSPC 100 may also comprise a microcontroller (not shown) for control of the logic.

FIG. 8 shows a DC power distribution and protection system that is similar to DC power distribution and protection system of FIG. 7 except that the SSPC 100 located in the positive voltage rail 3 is a bidirectional SSPC 100 and thus able to isolate voltage rail 3 in both directions.

According to FIG. 8, the bidirectional SSPC comprises two semiconductor switches S1, S2 with antiparallel diodes D1, D2 connected in common source/emitter configuration. The antiparallel diodes D1, D2 give current that flows in the opposite direction a path to flow. Without the diodes D, inductive currents would cease instantly, generating high voltage peaks. The switches S1, S2 are controlled by the respective gate voltage through a gate driver 110. The system further comprises two inductances L1, L2, one before switch S1 and one behind switch S2, wherein the inductances L1, L2 are configured to limit the rate of rise of current in case of a short-circuit fault.

In other embodiments, semiconductor switches are also arranged in the negative voltage rail 4.

One limitation of the systems of FIGS. 7 and 8 lies in size, weight and power loss of the semiconductor switches. To increase the current capacity and/or to reduce the voltage drop and power loss, each switching instance S1, S2 may be implemented by paralleling a plurality of semiconductor switches.

This is the case in the embodiment of FIG. 1. FIG. 1 depicts DC power distribution and protection system with the same basic arrangement as the system of FIG. 8. Accordingly, the DC power distribution and protection system comprises a DC power source 2 having a positive terminal 21 and a negative terminal 22, a power bus having a positive voltage rail 3 and a negative voltage rail 4, an SSPC 100, a load R, a capacitive load C₀, and several inductances L1-L4, wherein inductances L1, L2 are arranged in the positive voltage rail 3 and inductances L3, L4 are arranged in the negative voltage rail 4.

The SSPC 100 comprises two switching instances S1, S2, wherein each of the switching instances comprises of a plurality of semiconductor switches S11-S15, S21-S25 which are arranged in parallel. Each of the semiconductor switches S11-S15, S21-S25 comprises a transistor and a bypass diode as discussed with respect to FIGS. 7 and 8. The SSPC 100 further comprises two gate drivers 111, 112 for the semiconductor switches S11-S15, S21-S25 of the first and second switching instances S1, S2. It is pointed out that the gate drivers 111, 112 are depicted schematically only. In another embodiment, there may be provided individual gate drivers for the individual semiconductor switches S11-S15, S21-S25. The gate drivers may be commercially available off-the-shelf gate drivers in embodiments. The SSPC 100 may further comprise a microcontroller (not shown) for logic control.

Alternative to having two switching instances S1, S2, similar to FIG. 7, a unidirectional SSPC with a single switching instance S1 may implemented.

Further, it is pointed out that switching instances may be additionally or alternatively be implemented in the negative voltage rail 4.

It is further pointed out that the number of five parallel semiconductor switches in the switching instances S1, S2 is to be understood as an example only. The number of parallel devices is determined by the current requirements of the SSPC 100.

By paralleling a plurality of semiconductor switches S11-S15, S21-S25 in the switching instances S1, S2, current capacity can be increased and/or voltage drop and power loss can be reduced. However, switching devices may fail due to multiple reasons, such as overvoltage, **EMI,** high dv/dt, unequal current sharing, manufacturing defects, etc. With a large number of parallel semiconductor switches, there is an increased risk that failure of a single semiconductor switch can lead to failure of the complete SSPC 100 or require shutdown of the complete SSPC 100, this leading to a disruption of the system.

To avoid this risk, the DC power distribution and protection system of FIG. 1 implements further components which allow to service the DC power distribution and protection system by removing a faulty semiconductor switch without damaging the other semiconductor switches.

To implement such function, the DC power distribution and protection system further comprises an auxiliary switching instance SA which is arranged between the positive voltage rail 3 and the negative voltage rail 4. More particularly, the auxiliary switching instance SA is arranged such that it is connected with one terminal to the negative voltage rail 4 and with another other terminal to the positive voltage rail 3, wherein the connection to the positive voltage rail 3 is such that the connection is at a point 35 between the first and second switching instances S1, S2. Thereby, current guided through the auxiliary switching instance SA may be directed either through the switching instance S1 or the switching instance S2.

The depicted embodiment, the auxiliary switching instance SA comprises two parallel semiconductor switches SA1, SA2, but this is to be understood as an example only. Alternatively, there may be a single semiconductor switch or more than two semiconductor switches. Each semiconductor switch SA1, SA2 comprises a transistor (such as MOSFET) and a bypass diode. A gate driver 113 is provided which drives the gates of the semiconductor switches SA1, SA2. The gate driver 113 may be a separate gate driver or be integrated into a common gate driver. Also, individual gate drivers for switches SA1, SA2 may be provided for.

Further, a controller 5 is provided which is depicted schematically. The controller 5 is configured to receive information if one of the semiconductor switches S11-S15, S21-S25 has a fault condition through input lines 51. Such information may be provided from the gate drivers 111, 112 or from sensor elements associated with the individual semiconductor switches (such as thermal sensors). For example, if one of the semiconductor switches of switching instances S1, S2 is short-circuited, the respective gate driver (such as gate drivers 111, 112 or an individual gate driver) will flag an error signal that is received by controller 5 through input lines 51.

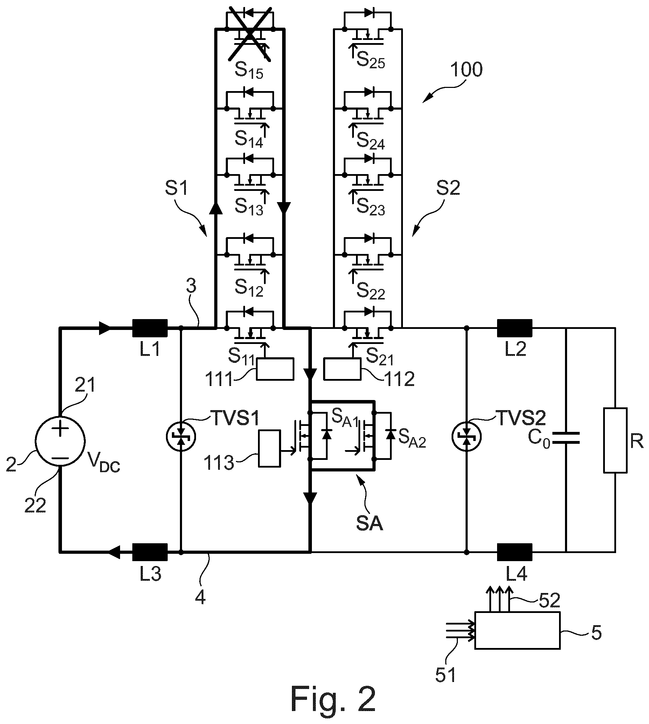

In case a fault condition of a particular semiconductor switch is detected, the controller 5 is further configured to control the respective switching instance S1, S2 and the auxiliary switching instance SA such that a short-circuit current flows through the auxiliary switching instance SA. It automatically also flows through a faulty semiconductor switch as the semiconductor switches are switched off such that there is current flow through a faulty semiconductor switch only. This is shown by way of example in FIG. 2. In FIG. 2, semiconductor switch S15 of switching instance S1 has experienced a fault such as a short-circuit condition. Accordingly, it has to be removed to allow further operation of the SSPC 100. To this end, the auxiliary semiconductor switches SA1 and SA2 are switched ON, thereby providing a short-circuit current between the positive voltage rail 3 and the negative voltage rail 4.

At the same time, in switching instance S1 semiconductor switches S11 to S15 are switched OFF such that the current passes the faulty (short-circuited) semiconductor switch S15 only. To achieve this, the controller 5 provides respective control signals 52 to the gate driver 111 through output lines 52. Accordingly, the short-circuit current is guided through auxiliary semiconductor switches SA1 and SA2 and the faulty semiconductor switch S15 only. FIG. 2 indicates the direction and path of the short-circuit current. As the short-circuit current is concentrated on the faulty semiconductor switch S15, the faulty semiconductor switch S15 is burned by the short-circuit and, thereby, removed from the switching instance. In particular, a previous short-circuit of the semiconductor switch S15 is transformed by the burning into an open state of the semiconductor switch S15.

The controller 5 may comprise a processor for executing instructions and a memory which is coupled to the processor and in which instructions are stored which, when executed by the processor, cause the processor to perform said functions of receiving information about the semiconductor switches and controlling the auxiliary switching instance and the semiconductor switches. The controller 5 may be a separate unit or may be integrated into a common gate driver or one of the gate drivers 111, 112, 113 or may be integrated into a microcontroller of the SSPC 100. Also, the controller 5 may communicate with other control devices of the system.

The antiparallel diode of the semiconductor switch S15 supports circulating current following a short circuit. In a post short circuit condition there will be a continued current flow due to line inductance that needs to be supported, and a conduction path should be provided to avoid overvoltage.

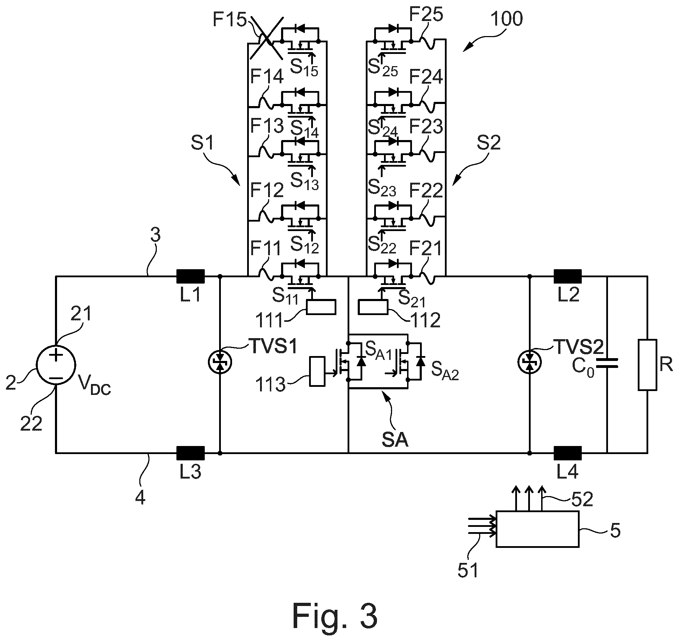

FIG. 3 depicts an embodiment which is similar to the embodiment of FIGS. 1 and 2 except that each of the semiconductor switches S11-S15, S21-S25 is arranged in series with a series fuse F11-15, F21-F25. In this embodiment, in case of a short-circuit through a faulty semiconductor switch, it is not the faulty semiconductor switch but the corresponding fuse which is burned. For example, in the embodiment of FIG. 3, it is schematically depicted that fuse F15 is burned. The effect is the same, namely, the faulty semiconductor switch (here: S15) is removed from the switching instance.

The number of parallel auxiliary devices of auxiliary switching instance SA is determined by the current requirement of the fuses and/or the current requirement to open circuit of the semiconductor switches (such as MOSFETs) and/or by the number of failed devices that are allowed to be cleared in the topology (at system level it can be determined whether it is allowed to open one or more than one failed switch).

When providing for a short-circuit to remove the faulty semiconductor switch in the above embodiments, the controller 5 controls the auxiliary switching instance SA such that a pre-determined continuous stream of pulses is applied when a fault condition is present. This allows the fuse or semiconductor switch to be blown off safely without damaging the auxiliary semiconductor switches SA1, SA2. The continuous pulse stream may be pre-determined based on the voltage at an input temperature or output temperature of a heat sink associated with the auxiliary switching instance SA. The data may be stored in a look-up table and referred to obtain the suitable sequence based on the operating condition of the system.

Also, the sequence of pulses may be interrupted for pre-determined intervals, allowing the auxiliary semiconductor switches SA1, SA2 to recover during the intervals.

In order to terminate the short-circuit condition and the operation of the auxiliary semiconductor switches SA1, SA2, a confirmation needs to be received by the controller 5 that the faulty semiconductor switch has been successfully removed. Such confirmation can be deducted from monitoring the short-circuit current. When the faulty semiconductor switch has been removed, the short-circuit current through the auxiliary semiconductor switches SA1, SA2 stops.

It is pointed out that in FIGS. 1, 2 and 3 there are also arranged two transient voltage suppressor diodes TVS1, TVS2 between the positive voltage rail 3 and the negative voltage rail 4, one before the SSPC 101 and one behind the SSPC 100, wherein this is optional. Such transient voltage suppressor diodes are designed to clamp transient voltages.

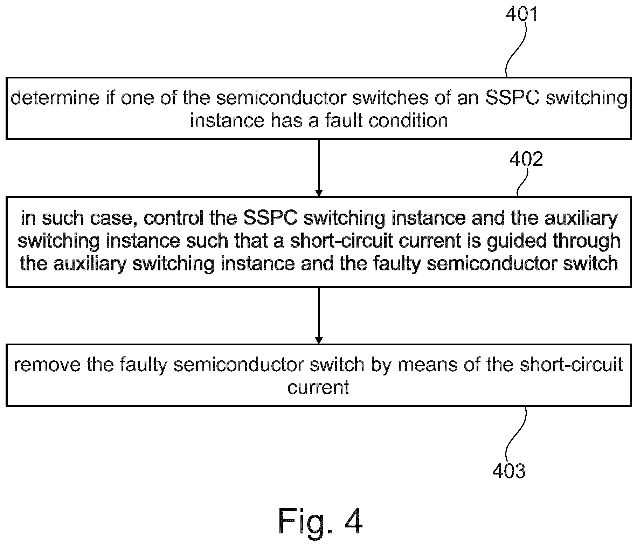

FIG. 4 is a flowchart of a method for servicing a DC power distribution and protection system, such as the DC power distribution and protection system of FIGS. 1 to 3. In step 401, it is determined if one of the semiconductor switches arranged in parallel of a switching instance of an SSPC has a fault. The switching instance could be switching instance S1 or S2 of the above embodiments. Such determination may be made through a controller such as controller 5 of FIGS. 1 to 3.

If this is the case, in step 402, the SSCP switching instance and the auxiliary switching instance are controlled such that a short-circuit current is guided through the auxiliary switching instance and the faulty semiconductor switch. Finally, in step 403, the faulty semiconductor switch is removed by means of the short-circuit current. Removal of the faulty semiconductor switch may be affected by burning the faulty semiconductor switch itself by means of the heat created by the short-circuit current or by burning a fuse or other element arranged series with the faulty semiconductor switch.

As discussed, a fault condition may be indicated to controller 5 of FIGS. 1 to 3 by means of an error flag of a gate driver. However, a gate driver error flag can be provided for multiple reasons. Therefore, in some embodiments, a diagnosis test is first carried out in order to eliminate other conditions and to get a clear indication of a fault of a semiconductor switch. Such diagnosis test may comprise setting all semiconductor switches S11-S15, S21-S25 into the OFF state while turning the auxiliary switching SA instance ON with a frequency pulse pattern. If there is a short-circuited semiconductor switch, the current will flow through the short-circuited semiconductor switch.

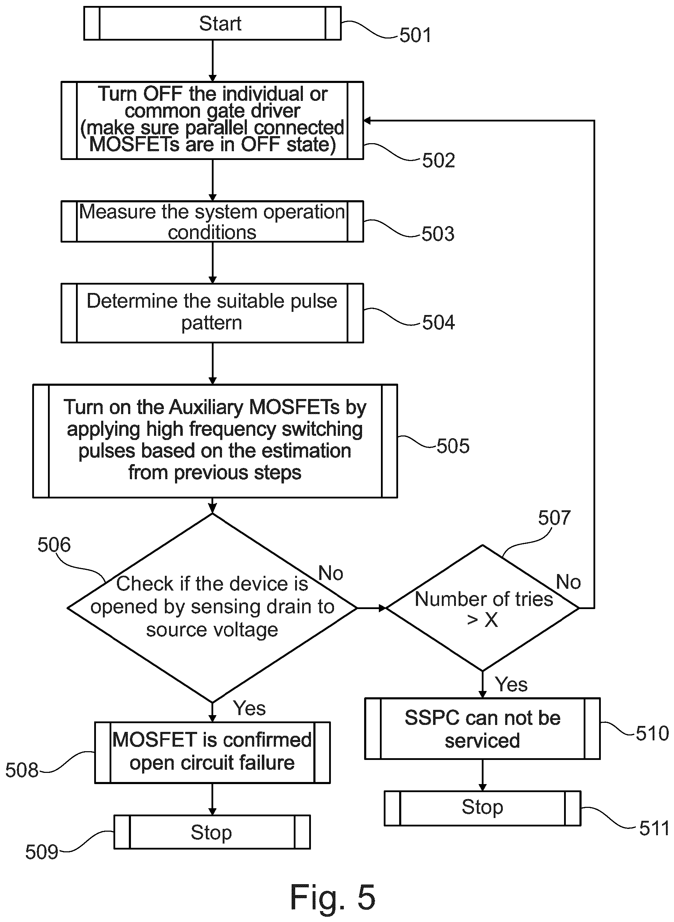

Further, removing a faulty semiconductor switch by providing a short-circuit condition may not always be successful and, accordingly, there may be situations in which it is necessary to declare that the SSPC is not serviceable. A respective sequence of steps is discussed with respect to FIG. 5, wherein it is assumed that the semiconductor switches are implemented as MOSFETs.

Start (step 501) indicates that a fault has been detected. Next, the individual or common gate driver(s) are turned OFF (such as gate drivers 111, 112 of FIGS. 1 to 3) in step 502. This is to make sure that all parallel connected MOSFETs of the respective switching instance are in the OFF state. Next, in step 503, the system operating conditions are measured. Subsequently, in step 504, a suitable pulse pattern for the auxiliary switching instance is determined. Subsequently, in step 405, the auxiliary switching instance, namely, the auxiliary MOSFETs are turned ON by applying high frequency switching pulses based on the estimation of the previous step 504. Application of such high frequency pulses may be through gate driver 113 of FIGS. 1 to 3, wherein controller 5 may provide respective control signals to the gate driver 113. Step 405 leads to a short-circuit pulsed current that is guided through the auxiliary MOSFETs and the faulty semiconductor switch (through which the current flows even though the switch has been switched OFF).

In step 506, it is checked if the faulty device/MOSFET is opened (in the sense that a previous short-circuit has been removed). This is done by sensing the drain to source voltage of the MOSFET. If the device/MOSFET has been opened by the short-circuit current, it is confirmed in step 508 that the MOSFET now has an open circuit failure and thus has been successfully removed. The method stops at step 509 in such case.

If the device/MOSFET has not been opened by the short-circuit current, the method goes into a loop and back to step 502, wherein in step 507 it is checked how many times the loop has been gone through. If this number is larger than a predefined number X, it is determined in step 510 that the SSPC cannot be serviced and the method stops at step 511 then. Otherwise, the loop is entered at step 502.

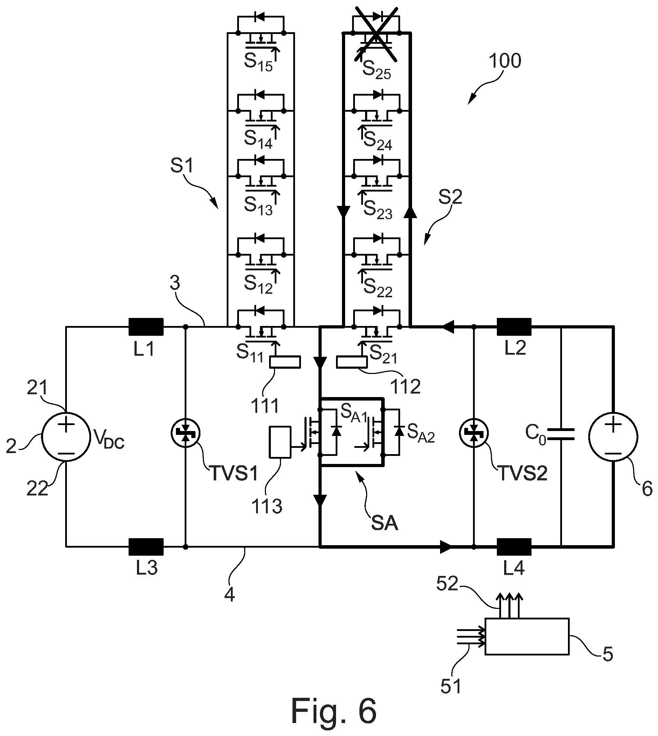

FIG. 6 depicts a further embodiment of a DC power distribution and protection system. The basic architecture is the same as in the embodiment of FIG. 1. The only difference lies in that the load R of FIG. 1 has been replaced by another DC power source 6. However, the power source 6 may be a load as well, wherein a particular condition of the load is considered in which energy is provided into the power bus. For example, power source 6 may be an electric drive when acting as a generator (when converting mechanical energy back into electrical energy).

Further, FIG. 6 considers the example situation in which a semiconductor switch of the second switching instance S2 has a fault, namely, semiconductor switch 25. In this case, the operation is in principle the same as a discussed with respect to FIG. 2, wherein, however, the pulsed short-circuit current is guided through DC power source 6, auxiliary semiconductor switches SA1, SA2 and faulty semiconductor switch 25 of switching instance S2. FIG. 6 indicates the direction and path of the short-circuit current.

It should be understood that the above description is intended for illustrative purposes only, and is not intended to limit the scope of the present disclosure in any way. Also, those skilled in the art will appreciate that other aspects of the disclosure can be obtained from a study of the drawings, the disclosure and the appended claims. All methods described herein can be performed in any suitable order unless otherwise indicated herein or otherwise clearly contradicted by context. Various features of the various embodiments disclosed herein can be combined in different combinations to create new embodiments within the scope of the present disclosure. In particular, the disclosure extends to and includes all combinations and sub-combinations of one or more features described herein. Any ranges given herein include any and all specific values within the range and any and all sub-ranges within the given range.

## Claims

1. A DC power distribution and protection system comprising:
a DC power source (2) having a positive terminal (21) and a negative terminal (22);
a power bus (3, 4) connecting the power source (2) and a load (R), the power bus comprising a positive voltage rail (3) connected to the positive terminal (21) and a negative voltage rail (4) connected to the negative terminal (22);
a solid state power controller (100) arranged in the positive voltage rail (3) or negative voltage rail (4), wherein the solid state power controller (100) comprises a first switching instance (S1, S2) that comprises a plurality of semiconductor switches (S11-S15, S21-S25) arranged in parallel;
an auxiliary switching instance (SA) arranged between the positive voltage rail (3) and the negative voltage rail (4); and
a controller (5) configured to receive information or determine that one of the semiconductor switches (S11-S15, S21-S25) of the first switching instance (S1, S2) has a fault condition;
wherein, in such case, the controller (5) is further configured to control the first switching instance (S1, S2) and the auxiliary switching instance (SA) such that the semiconductor switches (S11-S15, S21-S25) of the first switching instance (S1, S2) are switched off, and the auxiliary switching instance (SA) is switched on, wherein a short-circuit current is guided through the auxiliary switching instance (SA) and the faulty semiconductor switch (S15, S24) in order to remove the faulty semiconductor switch (S15, S25).

2. The system of claim 1, wherein the controller (5) is configured to operate the auxiliary switching instance (SA) such that a pre-determined continuous stream of pulses is applied when a fault condition is present to control the short circuit current and duration.

3. The system of claim 1 or 2, wherein the auxiliary switching instance (SA) comprises a plurality of semiconductor switches (SA1, SA2) arranged in parallel, wherein the semiconductor switches (SA1, SA2) of the auxiliary switching instance (SA) are controlled by the controller (5) to be switched on when a fault condition is present.

4. The system of any preceding claim, wherein the short-circuit current is provided such that the faulty semiconductor switch (S15, S25) is burned by the short-circuit current.

5. The system of any one of claims 1 to 3, wherein a series fuse (F11-F15, F21-F25) is arranged in series with each of the semiconductor switches (S11-S15, S21-S25), wherein the short-circuit current is provided such that the series fuse (F15) associated with the faulty semiconductor switch (S15) is burned in order to remove the faulty semiconductor switch (S15).

6. The system of any preceding claim, wherein the controller (5) is configured to control the auxiliary switching instance (SA) such that the auxiliary switching instance (SA) is shut off during normal operation of the solid state power controller (100).

7. The system of any preceding claim, wherein the multiple semiconductor switches (S11-S15, S21-S25) of the first switching instance (S1, S2) are controlled by a single gate driver (111, 112).

8. The system of any one of claims 1 to 6, wherein the multiple semiconductor switches (S11-S15, S21-S25) of the first switching instance (S1, S2) are controlled by individual gate drivers.

9. The system of claim 7 or 8, wherein the controller (5) is configured to determine that one of the semiconductor switches (S11-S15, S21-S25) of first switching instance (S1, S2) has a fault by means of the gate driver (111, 112) providing an error signal for the faulty switch to the controller (5) in such case.

10. The system of any preceding claim, wherein the controller (5) is configured to run a diagnosis test when receiving an error indication before determining that a particular switch (S11-S15, S21-S25) has a fault, wherein the diagnosis test comprises setting all semiconductor switches (S11-S15, S21-S25) of the first switching instance (S1, S2) into the OFF state while turning the auxiliary switching (SA) instance ON with a frequency pulse pattern .

11. The system of any preceding claim, wherein the solid state power controller (5) further comprises a second switching instance (S2, S1) arranged in the same voltage rail (3, 4) as the first switching instance (S1, S2), wherein the second switching instance (S2, S1) also comprises a plurality of semiconductor switches (S21-S25, S11-S15) arranged in parallel, and wherein the controller (5) is configured to receive information if one of the semiconductor switches (S25, S15) of the second switching instance (S2, S1) has a fault condition, and, in such case, the controller (5) is further configured to control the second switching instance (S2, S1) and the auxiliary switching instance (SA) such that the semiconductor switches (S21-S25, S11-S15) of the second first switching instance (S2, S1) are switched off, and the auxiliary switching instance (SA) is switched on, wherein a short-circuit current is guided through the auxiliary switching instance (SA) and the faulty semiconductor switch (S25, S15) in order to remove the faulty semiconductor switch.

12. The system of claim 11, wherein the auxiliary switching instance (SA) is arranged between the positive voltage rail (3) and the negative voltage rail (4) such that one terminal of the auxiliary switching instance is connected to a point (35) in between the first and second switching instances (S1, S2).

13. A method for servicing a DC power distribution and protection system in case of failure of a semiconductor switch, wherein the DC power distribution and protection system comprises:
a DC power source (2) having a positive terminal (21) and a negative terminal (22);
a power bus (3, 4) connecting the power source (2) and a load (R), the power bus comprising a positive voltage rail (3) connected to the positive terminal (21) and a negative voltage rail (4) connected to the negative terminal (22);
a solid state power controller (100) arranged in the positive voltage rail (3) or negative voltage rail (4), wherein the solid state power controller (100) comprises a first switching instance (S1, S2) that comprises a plurality of semiconductor switches (S11-S15, S21-S25) arranged in parallel; and
an auxiliary switching instance (SA) arranged between the positive voltage rail (3) and the negative voltage rail (4);
the method comprising the steps of:
determining (401) if one of the semiconductor switches (S11-S15, S21-S25) of the first switching instance (S1, S2) has a fault condition;
in such case controlling (402) the first switching instance (S1, S2) and the auxiliary switching instance (SA) such that a short-circuit current is guided through the auxiliary switching instance (S1, S2) and the faulty semiconductor switch (S15, S25); and
removing (403) the faulty semiconductor switch (S15, S25) by means of the short-circuit current.

14. The method of claim 13, wherein the faulty semiconductor switch (S15, S25) or a series fuse (F15) arranged in series with the faulty semiconductor switch (S15) is burned by the short-circuit current.

15. The method of claim 13 or 14, wherein the auxiliary switching instance (SA) is operated by applying a pre-determined continuous stream of pulses when a fault condition is present to control the short circuit current and duration.
